# EUROPÄISCHE PATENTSCHRIFT

(11) **EP 0 820 218 B1**
(45) Veröffentlichungstag und Bekanntmachung des Hinweises auf die Patenterteilung: **20.01.1999**
(21) Anmeldenummer: 97108428.0
(22) Anmeldetag: 25.05.1997
(51) Int. Cl.: H05K 9/00

(54) **Elektronisches Gerät sowie Abschirmformteil für ein elektronisches Gerät**
Electronic device and shielding cap for an electronic device
Dispositif électronique et pièce de blindage d'un dispositif électronique

(30) Priorität: 20.07.1996 DE 19629230
(43) Veröffentlichungstag der Anmeldung: 21.01.1998
(73) Patentinhaber: Siegfried Schaal Metallveredelung GmbH & Co., 72517 Sigmaringendorf (DE)
(72) Erfinder: Schaal, Siegfried, 72517 Sigmaringendorf (DE)
(74) Vertreter: Ostertag, Ulrich

(56) Entgegenhaltungen:
- WO-A-95/34423
- PATENT ABSTRACTS OF JAPAN vol. 013, no. 493 (E-842), 8.November 1989 & JP 01 198099 A (TOSHIBA CORP;OTHERS: 01), 9.August 1989,
- PATENT ABSTRACTS OF JAPAN vol. 013, no. 268 (E-775), 20.Juni 1989 & JP 01 057798 A (TOSHIBA CORP), 6.März 1989,

## Beschreibung

Die Erfindung betrifft ein elektronisches Gerät mit
a) einem aus zwei Teilen lösbar zusammengesetzten Außengehäuse;
b) im Innenraum des Außengehäuses angeordneten elektronischen Bauelementen;
c) einer die Bauelemente innerhalb des Außengehäuses umgebenden Abschirmung aus elektrisch leitendem Material,
sowie ein Abschirm-Formteil für ein elektronisches Gerät.

Um elektronische, elektrische, magnetische oder elektromagnetische Bauelemente vor Fremdfeldern und -strahlungen, die Störungen hervorrufen können, zu schützen, werden die die Bauelemente aufnehmenden Außengehäuse, beispielsweise die Gehäuseteile eines Fernsprechapparates, vielfach auf der Innenseite mit einer abschirmenden metallischen oder Metall enthaltenden Beschichtung versehen. Dies bedeutet, daß verhältnismäßig große Oberflächen zu beschichten sind, was teuer ist. Darüber hinaus ist die Abschirmwirkung derartiger Beschichtungen eingeschränkt, da die Gehäuseteile mitunter größere Öffnungen aufweisen, durch welche Störstrahlung oder störende Felder zu den elektronischen Bauelementen gelangen können. Vor allem aber ist von Nachteil, daß die Aufbringung der Beschichtung häufig deshalb zeitaufwendig und kostspielig ist, weil die Außengehäuse der elektronischen Geräte besonders zu behandeln sind. Es sind nämlich deren Ausnehmungen und/oder Freisparungen mit Hilfe von Masken vor der Beschichtung abzudecken; diese müssen nach dem Beschichten wieder entfernt werden.

In der EP-A-0 805 619, die unter Artikel 54(3) EPÜ fällt und die der nicht vorveröffentlichten DE-A-196 17 656.5 entspricht, wird aus diesem Grunde vorgeschlagen, die Abschirmung zumindest teilweise als Kunststoff-Formteil auszugestalten, das aus einem thermoplastisch verformbaren Kunststoff besteht. Auf dessen Innenwand und/oder Außenwand ist eine Beschichtung vorgesehen, die elektrisch leitfähig ist. Dieses Abschirm-Formteil wird beim Gegenstand der genannten älteren deutschen Patentanmeldung von einer Seite her gegen ein weiteres Teil, welches die Abschirmung vervollständigt, angedrückt und unter Zwischenschaltung einer elektrisch leitenden Dichtung zu einer hochfrequenzmäßig dichten Einheit zusammengefügt. Die beiden Teile, welche zusammen die Abschirmung bilden, werden lösbar (durch Formschluß) oder auch durch Verkleben aneinander befestigt. Diese an und für sich sehr funktionstüchtige Art der Abschirmung ist jedoch noch etwas aufwendig, sowohl was die Art der Verbindung der beiden die Abschirmung bildenden Teile betrifft als auch hinsichtlich der elektrisch leitenden Dichtung, die vergleichsweise teuer ist.

EP-A-0 805 619 offenbart insbesondere nicht einen umlaufenden Kontaktierungsflansch, der in bewegliche Lamellen unterteilt ist.

Aufgabe der vorliegenden Erfindung ist es, ein elektronisches Gerät der eingangs genannten Art derart auszugestalten, daß die elektronischen Bauelemente auf einfache Weise und preiswert vor elektromagnetischen Störfeldern geschützt sind.

Diese Aufgabe wird erfindungsgemäß dadurch gelöst, daß
d) die Abschirmung von einem Abschirm-Formteil gebildet ist, welches mindestens zwei Teile umfaßt;
e) mindestens eines der Teile des Abschirm-Formteiles als thermoplastisch verformbares Kunsttoffteil ausgestaltet und auf der Innenwand und/oder der Außenwand ganz oder teilweise mit einer elektrisch leitenden Beschichtung versehen ist;
f) das als thermoplastisch veformbare Kunststoffteil ausgebildete Teil des Abschirm-Formteils einen umlaufenden Kontaktierungsflansch aufweist, der durch eine Mehrzahl von Schlitzen in bewegliche Lamellen unterteilt ist;
g) die elektrisch leitende Beschichtung des Kontaktierungsflansches an einem elektrisch leitenden, auf Massepotential liegenden Bereich des anderen Teils des Abschirm-Formteiles anliegt;
h) zwischen der Rückseite des Kontaktierungsflansches und dem Außengehäuse ein elektrisch nicht leitendes, umlaufendes Federelement angeordnet ist, welches den Kontaktierungsflansch gegen den elektrisch leitenden, auf Massepotential liegenden Bereich des anderen Teiles des Abschirm-Formteiles drückt.

Erfindungsgemäß wird also die Abschirmung nicht mehr direkt an der Innenfläche des Außengehäuses des elektronischen Gerätes angebracht sondern als "zweite Haut", die in Form des Kunststoffteiles leicht herstellbar ist, im Innenraum des Außengehäuses untergebracht. Die Ausgestaltung kann im Einzelfall so gewählt werden, daß nicht mehr der gesamte Innenraum des elektronischen Gerätes sondern nur diejenige Gruppe bzw. diejenigen Gruppen von Bauelementen durch speziell zugeordnete Abschirm-Formteile vor Störstrahlungen geschützt werden, die einer solchen Abschirmung bedürfen. Da die erfindungsgemäß eingesetzten Abschirm-Formteile keine Sichtfunktion ausüben, können sie ganz nach Zweckmäßigkeits-Gesichtspunkten ausgelegt werden, ohne Rücksicht auf "Design" nehmen zu müssen. Durch die Schlitzung des Kontaktierungsflansches des einen Teils des Abschirm-Formteils entstehen bewegliche (flexible) Lamellen, die unter dem Einfluß des umlaufenden Federelementes auch bei Unebenheiten der miteinander zu verbindenden Teile zuverlässig gegen das komplementäre Teil des Abschirm-Formteiles angedrückt werden, so daß trotz einer nicht permanenten Verbindung dieser beiden Teile stets überall ein guter elektrischer Kontakt sichergestellt ist. Da das Federelement auf der Rückseite des Kontaktierungsflansches angebracht ist, braucht es selbst elektrisch nicht leitend zu sein, was die Kosten weiter reduziert.

Daher ist es nach einer besonders bevorzugten Ausgestaltung der Erfindung möglich, daß das umlaufende Federelement eine strangförmig aufgetragene Elastomer-Raupe ist. Elastomer-Materialien, aus denen sich mittels eines Dispensers derartige Raupen herstellen lassen, sind Massenprodukte und entsprechend preiswert.

Bevorzugt wird ferner, wenn mindestens ein Teil des Außengehäuses an seiner Innenfläche mit einer umlaufenden, herausragenden Rippe versehen ist, welche einer Linie folgt, die dem Verlauf des Kontaktierungsflansches entspricht. Beim Zusammenfügen der beiden Teile des Außengehäuses wird also gerade die Kontaktfläche zwischen den beiden Teilen des Abschirm-Formteiles von dieser Rippe druckmäßig beaufschlagt, was die Zuverlässigkeit der Kontaktbildung weiter erhöht.

Besonders bevorzugt wird diejenige Ausgestaltung der Erfindung, bei welcher eines der beiden Teile des Abschirm-Formteiles von einer elektronischen Leiterplatte gebildet ist, welche eine durchgehende Beschichtung aus elektrisch leitendem Material trägt. Diese elektronische Leiterplatte, welche ohnehin erforderlich ist, bildet gleichzeitig eine Art "Deckel" für das gegenüberliegende Teil des Abschirm-Formteils.

Vorteilhaft ist weiter, wenn der Kontaktierungsflansch des als thermoplastisch verformbares Kunststoffteil ausgebildeten Teils des Abschirm-Formteils einen, von dem anderen Teil des Abschirm-Formteils gesehen, konvex gekrümmten, umlaufenden Wulst umfaßt. Die Berührung zwischen dem einen und dem anderen Teil des Abschirm-Formteiles erfolgt also bei dieser Ausgestaltung linienhaft, was den elektrischen Kontakt weiter verbessert.

Aufgabe der vorliegenden Erfindung ist es ferner, ein Abschirm-Formteil zur Verwendung in einem elektronischen Gerät zu schaffen, welches ebenfalls sowohl in der Herstellung als auch in der späteren Montage im elektronischen Gerät selbst besonders preisgünstig ist.

Dieser Teil der Aufgabe wird durch ein Abschirm-Formteil mit den im Anspruch 6 angegebenen Merkmalen gelöst. Vorteilhafte Weiterbildungen dieses Abschirm-Formteils sind in den Ansprüchen 7 und 8 angegeben. Wegen der mit den verschiedenen Merkmalen erzielten Wirkungen und Vorteile wird auf die obigen Ausführungen zum elektronischen Gerät verwiesen, die insoweit entsprechend Gültigkeit besitzen.

Ein Ausführungsbeispiel der Erfindung wird nachfolgend anhand der Zeichnung erläutert; es zeigen
- Figur 1:: einen Schnitt durch ein elektronisches Gerät;
- Figur 2:: in vergrößertem Maßstabe die Draufsicht auf einen Teil des Randbereiches der in dem Gerät von Figur 1 enthaltenen Abschirm-Formkappe.

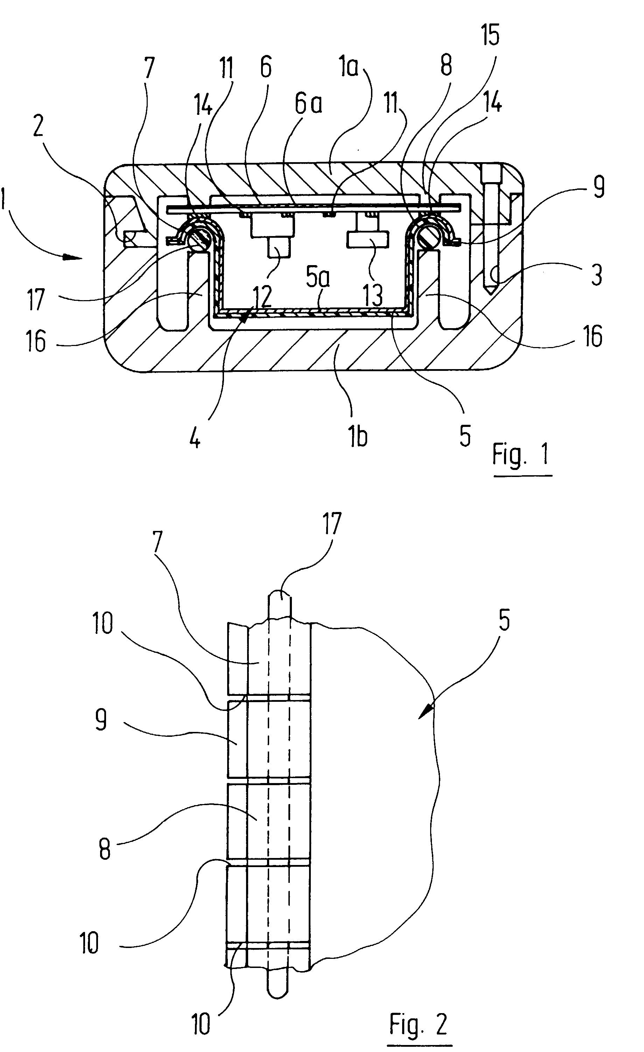

In Figur 1 ist schematisch ein Schnitt durch ein elektronisches Gerät dargestellt, bei dem es sich z.B. um einen Fernsprechapparat ("Handy") handeln kann. Das Gerät umfaßt ein aus zwei Teilen la und 1b zusammengesetztes Außengehäuse 1. An der in Figur 1 linken Seite sind die beiden Teile la und 1b durch eine Schnappverbindung 2 formschlüssig miteinander verbunden, während die Befestigung der beiden Teile la und 1b aneinander an der gegenüberliegenden Seite mit Hilfe von Schrauben erfolgt. Die entsprechende Schraubbohrung ist in Figur 1 mit dem Bezugszeichen 3 gekennzeichnet.

In dem Außengehäuse 1 des Fernsprechapparates ist ein Abschirm-Formteil 4 in noch zu beschreibender Weise befestigt, welches bei dem dargestellten Ausführungsbeispiel eine Abschirm-Formkappe 5 und eine diese oben deckelartig abschließende Leiterplatte 6 umfaßt.

Bei der Abschirm-Formkappe 5 handelt es sich um ein im Tiefzieh- oder Spritzgießverfahren hergestelltes thermoplastisch verformbares Kunststoff-Formteil, das auf der Innenwandung mit einer metallischen Beschichtung 5a versehen ist. Diese ist nach einem bekannten Verfahren, beispielsweise durch galvanische oder autokatalytisch-chemische Abscheidung, durch Aufdampfen, durch Beschichten mit einem Leitlack oder durch thermisches Spritzen aufgebracht. Als Material kommen vornehmlich Kupfer, eine Kupfer-Nickel-Legierung oder ein anderes elektrisch hochleitfähiges Metall in Frage.

Entlang der Ränder der Abschirm-Formkappe 5 erstreckt sich ein Kontaktierungsflansch 7, der seinerseits aus einem innenliegenden, im Querschnitt etwa halbkreisförmig gekrümmten Kontaktierungswulst 8 und einem äußeren, ebenen Randsteg 9 zusammengesetzt ist.

In den Kontaktierungsflansch 7 sind von außen her in regelmäßigen Abständen und bis zu einer bestimmten Tiefe Schlitze 10 eingebracht. Durch diese Schlitze 10 ist der Kontaktierungsflansch 7 in eine Vielzahl von beweglichen bzw. flexiblen Lamellen unterteilt. Auf den Sinn dieser Maßnahme wird weiter unten eingegangen.

Die elektronische Leiterplatte 6 ist ebenfalls mit einer metallischen Beschichtung 6a versehen; zum Material und zur Aufbringungsart gilt das oben für die metallische Beschichtung 5a der Abschirm-Formkappe 5 Gesagte entsprechend. Auf der Innenseite, also auf der der Abschirm-Formkappe 5 zugewandten Seite, trägt die elektronische Leiterplatte 6 in an und für sich bekannter Weise ein Muster von Leiterbahnen 11, die mit bestimmten, hier nicht näher interessierenden elektronischen Bauelementen 12, 13 verbunden sind. Entlang einer Linie, welche dem Verlauf des Kontaktierungswulstes 8 an der Abschirm-Formkappe 5 entspricht, trägt die Leiterplatte 6 insbesondere eine auf Massepotential liegende Leiterbahn 14. Diese ist wiederum elektrisch mit der metallischen Beschichtung 6a der Leiterplatte 6 verbunden.

Wie der Figur 1 zu entnehmen ist, liegt in montiertem Zustand die auf Massepotential befindliche Leiterbahn 14 der Leiterplatte 6 am Scheitel des Kontaktierungswulstes 8 der Abschirm-Formkappe 5 an, so daß der Innenraum des aus Leiterplatte 6 und Abschirm-Formkappe 5 zusammengesetzten Abschirm-Formteiles 4 ringsum von metallischen Beschichtungen 5a und 6b umgeben ist und die an der Leiterplatte 6 angeschlossenen elektronischen Bauelemente 12, 13 in einem weitgehend feldfreien, abgeschirmten Raum angeordnet sind.

Das Abschirm-Formteil 4 ist zwischen den beiden Teilen 1a und 1b des Außengehäuses 1 in folgender Weise befestigt:

An das in Figur 1 obere Teil la des Außengehäuses 1 ist eine Niederhalterippe 15 angeformt, welche der Linie der auf Massepotential liegenden Leiterbahn 14, und damit auch der Linie des Kontaktierungswulstes 8 der Abschirm-Formkappe 5, folgt.

In entsprechender Weise ist an die in Figur 1 untere Hälfte 1b des Außengehäuses 1 eine umlaufende Distanzrippe 16 angeformt, welche derselben Linie folgt.

Zwischen der obere Stirnseite der Distanzrippe 16 und der unteren Seite des Kontaktierungswulstes 8 der Abschirm-Formkappe 5 ist eine umlaufende Raupe 17 aus einem nichtleitenden Elastomer-Material mittels eines entsprechenden Dispensers angebracht. Die Dimensionen der Bauteile sind so aufeinander abgestimmt, daß bei aneinander befestigten Teilen la, 1b des Außengehäuses 1 die Elastomer-Raupe 17 eine Kompression erfährt. Die - lokal durchaus variierenden - elastischen Deformationskräfte der Elastomer-Raupe 17 wirken auf die verschiedenen, durch die Schlitze 10 gebildeten Lamellen des Kontaktierungsflansches 7 der Abschirm-Formkappe 5, die auf diese Weise weitgehend unabhängig voneinander nach oben gegen die auf Massepotential liegende Leiterbahn 14 der elektronischen Leiterplatte 6 angedrückt werden. Durch diese Ausgestaltung werden Unebenheiten der eingesetzten Bauelemente weitestgehend ausgeglichen, so daß über den gesamten Kontaktierungsflansch 7 der Abschirm-Formkappe 5 hinweg ein guter elektrischer Kontakt zu der Leiterbahn 14 der Leiterplatte 6 hergestellt ist. Der Abstand benachbarter Schlitze 10 wird ebenso wie deren Tiefe und Breite an die Frequenz der abzuschirmenden Störstrahlung angepaßt. Diese geometrischen Größen können so gewählt werden, daß trotz der Erzielung des gewünschten Effektes (Bildung beweglicher Lamellen) die Abschirmwirkung vollkommen erhalten bleibt.

## Patentansprüche

1. Elektronisches Gerät mit
a) einem aus zwei Teilen (1a, 1b) lösbar zusammengesetzten Außengehäuse (1);
b) im Innenraum des Außengehäuses angeordneten elektronischen Bauelementen;
c) einer die Bauelemente innerhalb des Außengehäuses umgebenden Abschirmung aus elektrisch leitendem Material,
wobei
d) die Abschirmung von einem Abschirm-Formteil (4) gebildet ist, welches mindestens zwei Teile (5, 6) umfaßt;
e) mindestens eines der Teile (5) des Abschirm-Formteiles (4) als thermoplastisch verformbares Kunststoffteil ausgestaltet und auf der Innenwand und/oder der Außenwand ganz oder teilweise mit einer elektrisch leitenden Beschichtung (5a) versehen ist;
f) das als thermoplastisch verformbares Kunststoffteil ausgebildete Teil (5) des Abschirm-Formteils (4) einen umlaufenden Kontaktierungsflansch (7) aufweist, der durch eine Mehrzahl von Schlitzen (10) in bewegliche Lamellen unterteilt ist;
g) die elektrisch leitende Beschichtung (5a) des Kontaktierungsflansches (7) an einem elektrisch leitenden, auf Massepotential liegenden Bereich (14) des anderen Teils (6) des Abschirm-Formteiles (4) anliegt;
h) zwischen der Rückseite des Kontaktierungsflansches (7) und dem Außengehäuse (1) ein elektrisch nicht leitendes, umlaufendes Federelement (17) angeordnet ist, welches den Kontaktierungsflansch (7) gegen den elektrisch leitenden, auf Massepotential liegenden Bereich (14) des anderen Teiles (6) des Abschirm-Formteiles (4) drückt.

2. Elektronisches Gerät nach Anspruch 1, dadurch gekennzeichnet, daß das umlaufende Federelement (17) eine strangförmig aufgetragene Elastomer-Raupe ist.

3. Elektronisches Gerät nach Anspruch 1 oder 2, dadurch gekennzeichnet, daß mindestens ein Teil (1a, 1b) des Außengehäuses (1) an seiner Innenfläche mit einer umlaufenden, herausragenden Rippe (14, 16) versehen ist, welche einer Linie folgt, die dem Verlauf des Kontaktierungsflansches (7) entspricht.

4. Elektronisches Gerät nach einem der vorhergehenden Ansprüche, dadurch gekennzeichnet, daß eines (6) der beiden Teile (5, 6) des Abschirm-Formteiles (4) von einer elektronischen Leiterplatte gebildet ist, welche eine durchgehende Beschichtung (6a) aus elektrisch leitendem Material trägt.

5. Elektronisches Gerät nach einem der vorhergehenden Ansprüche, dadurch gekennzeichnet, daß der Kontaktierungsflansch (7) am als Kunststoffteil ausgebildeten Teil (5) des Abschirm-Formteils (4) einen, von dem anderen Teil (6) des Abschirm-Formteils (4) gesehen, konvex gekrümmten, umlaufenden Wulst (10) umfaßt.

6. Abschirm-Formteil zur Verwendung in einem elektronischen Gerät nach einem der Ansprüche 1 bis 5, wobei es
a) mindestens zwei Teile (5, 6) umfaßt;
b) mindestens eines der Teile (5) als thermoplastisch verformbares Kunststoffteil ausgestaltet und auf der Innenwand und/oder der Außenwand ganz oder teilweise mit einer elektrisch leitenden Beschichtung (5a) versehen ist;
c) das als thermoplastisch verformbares Kunststoffteil ausgebildete Teil (5) einen umlaufenden Kontaktierungsflansch (7) aufweist, der durch eine Mehrzahl von Schlitzen (10) in bewegliche Lamellen unterteilt ist.

7. Abschirm-Formteil nach Anspruch 6, dadurch gekennzeichnet, daß eines (6) der beiden Teile (5, 6) von einer elektronischen Leiterplatte gebildet ist, welche eine durchgehende Beschichtung (6a) aus elektrisch leitendem Material trägt.

8. Abschirm-Formteil nach Anspruch 6 oder 7, dadurch gekennzeichnet, daß der Kontaktierungsflansch (7) des thermoplastisch verformbares Kunststoffteil ausgebildeten Teils (5) einen, von dem anderen Teil (6) gesehen, konvex gekrümmten umlaufenden Wulst (10) umfaßt.

## Claims

1. Electronic instrument with
a) an outer casing (1) which is detachably assembled from two parts (1a, 1b);
b) electronic components arranged in the interior space of the outer casing;
c) a screen consisting of electrically conducting material surrounding the components within the outer casing,
wherein
d) the screen is formed by a screening moulding (4) which comprises at least two parts (5, 6);
e) at least one of the parts (5) of the screening moulding (4) is configured as a thermoplastically deformable plastic part and is provided on the inner wall and/or the outer wall, entirely or partially, with an electrically conducting coating (5a);
f) the part (5) of the screening moulding (4) taking the form of a thermoplastically deformable plastic part comprises a circumferential contacting flange (7) which is subdivided by a plurality of slots (10) into movable lamellae;
g) the electrically conducting coating (5a) of the contacting flange (7) abuts an electrically conducting region (14) at earth potential pertaining to the other part (6) of the screening moulding (4);
h) between the rear of the contacting flange (7) and the outer casing (1) an electrically non-conducting, circumferential spring element (17) is arranged which presses the contacting flange (7) against the electrically conducting region (14) at earth potential pertaining to the other part (6) of the screening moulding (4).

2. Electronic instrument according to Claim 1, characterised in that the circumferential spring element (17) is an elastomer bead applied in the form of a strand.

3. Electronic instrument according to Claim 1 or 2, characterised in that at least one part (1a, 1b) of the outer casing (1) is provided on its inner surface with a circumferential projecting rib (14, 16) which follows a line corresponding to the course of the contacting flange (7).

4. Electronic instrument according to one of the preceding claims, characterised in that one (6) of the two parts (5, 6) of the screening moulding (4) is formed by an electronic circuit board which bears an uninterrupted coating (6a) of electrically conducting material.

5. Electronic instrument according to one of the preceding claims, characterised in that the contacting flange (7) on the part (5) of the screening moulding (4) taking the form of a plastic part comprises a circumferential bulb (10) [sic] which is convexly curved, viewed from the other part (6) of the screening moulding (4).

6. screening moulding for use in an electronic instrument according to one of Claims 1 to 5, wherein
a) it comprises at least two parts (5, 6);
b) at least one of the parts (5) is configured as a thermoplastically deformable plastic part and is provided on the inner wall and/or the outer wall, entirely or partially, with an electrically conducting coating (5a);
c) the part (5) taking the form of a thermoplastically deformable plastic part comprises a circumferential contacting flange (7) which is subdivided by a plurality of slots (10) into movable lamellae.

7. Screening moulding according to Claim 6, characterised in that one (6) of the two parts (5, 6) is formed by an electronic circuit board which bears an uninterrupted coating (6a) of electrically conducting material.

8. Screening moulding according to Claim 6 or 7, characterised in that the contacting flange (7) of the part (5) taking the form of a thermoplastically deformable plastic part comprises a circumferential bulb (10) [sic] which is convexly curved, viewed from the other part (6).

## Revendications

1. Appareil électronique comprenant :
a) un boîtier extérieur (1) composé de deux parties (1a, 1b) assemblées de façon amovible,
b) des composants électroniques logés à l'intérieur du boîtier extérieur,
c) un blindage en un matériau conducteur de courant entourant les composants à l'intérieur du boîtier exténeur, sachant que
d) le blindage est formé par une pièce de blindage moulée (4) comprenant au moins deux parties (5, 6),
e) au moins l'une des parties (5) de la pièce de blindage moulée (4) est une pièce en matière plastique thermoplastique et est enduite sur la paroi intérieure et/ou extérieure, entièrement ou partiellement, d'un revêtement conducteur de courant (5a),
f) la partie (5) de la pièce de blindage moulée (4) qui est réalisée en tant que pièce en matière plastique thermoplastique présente une bride de contact faisant tout le tour (7), qui est divisée par de nombreuses fentes (10) en lamelles mobiles,
g) le revêtement conducteur de courant (5a) de la bride de contact (7) est appliqué contre une zone conductrice de courant (14) reliée à la masse de l'autre partie (6) de la pièce de blindage moulée (4),
h) entre la face arrière de la bride de contact (7) et le boîtier extérieur (1) est disposé un élément à ressort (17) non conducteur de courant et faisant tout le tour, qui appuie la bride de contact (7) contre la zone conductrice de courant (14) reliée à la masse de l'autre partie (6) de la pièce de blindage moulée (4).

2. Appareil électronique selon la revendication 1, caractérisé en ce que l'élément à ressort faisant tout le tour (17) est un boudin en élastomère.

3. Appareil électronique selon la revendication 1 ou 2, caractérisé en ce qu'au moins une partie (1a, 1b) du boîtier extérieur (1) est munie sur sa surface intérieure d'une nervure saillante faisant tout le tour (14, 16), qui suit un tracé correspondant à celui de la bride de contact (7).

4. Appareil électronique selon l'une des revendications précédentes, caractérisé en ce que l'une (6) des deux parties (5, 6) de la pièce de blindage moulée (4) est formée par une plaquette électronique qui porte un revêtement (6a) ininterrompu en une matière conductrice de courant.

5. Appareil électronique selon l'une des revendications précédentes, caractérisé en ce que la bride de contact (7) présente, sur la partie (5) de la pièce de blindage moulée (4) réalisée en matière plastique, un épaulement (8) qui, vu depuis l'autre partie (6) de la pièce de blindage moulée (4), est courbé de façon convexe.

6. Pièce de blindage moulée destinée à être mise en oeuvre dans un appareil électronique selon l'une des revendications 1 à 5, sachant que :
a) elle comprend deux parties (5, 6) ;
b) au moins l'une des parties (5) est une pièce en matière plastique thermoplastique et est enduite sur la paroi intérieure et/ou extérieure, entièrement ou partiellement, d'un revêtement conducteur de courant (5a) ;
c) la partie (5) qui est réalisée en tant que pièce en matière plastique thermoplastique présente une bride de contact faisant tout le tour (7), qui est divisée par de nombreuses fentes (10) en lamelles mobiles.

7. Pièce de blindage moulée selon la revendication 6, caractérisée en ce que l'une (6) des deux parties (5, 6) est formée par une plaquette électronique qui porte un revêtement (6a) ininterrompu en une matière conductrice de courant.

8. Pièce de blindage moulée selon la revendication 6 ou 7, caractérisée en ce que la bride de contact (7) de la partie (5) réalisée en tant que pièce en matière plastique thermoplastique comporte un épaulement (8) qui, vu depuis l'autre partie (6), est courbé de façon convexe.
